# EUROPEAN PATENT APPLICATION

(11) **EP 4 318 894 A1**
(43) Date of publication of application: **07.02.2024**
(21) Application number: 22784341.4
(22) Date of filing: 15.02.2022
(51) Int. Cl.: H02K 5/20, H02K 5/22, H05K 7/20, H02M 7/48

(54) **COOLING DEVICE FOR ELECTRICAL CONDUCTOR, POWER CONVERSION DEVICE, AND ROTARY ELECTRIC MACHINE**

(30) Priority: 06.04.2021 JP 2021064570
(71) Applicant: Mitsubishi Heavy Industries, Ltd., Tokyo 100-8332 (JP)
(72) Inventor: ONO, Kimihiro, Tokyo 100-8332 (JP)
(74) Representative: Studio Torta S.p.A.
(86) International application number: PCT/JP2022/005898
(87) International publication number: WO 2022/215356

(57) **Abstract**

A cooling device for an electrical conductor of the present disclosure includes: a cooling device body in which a flow path of refrigerant is formed, an opening portion communicating with the flow path being formed on an outer surface of the cooling device body; a conductor fixing portion which is allowed to be fixed an electrical conductor thereto; and an insulating base portion which is disposed between the conductor fixing portion and the cooling device body and is fixed to the cooling device body to block the opening portion, in which the cooling device body and the refrigerant are electrically insulated from the conductor fixing portion by the insulating base portion and heat of the conductor fixing portion is allowed to be transferred to the cooling device body and the refrigerant through the insulating base portion. The insulating base portion includes an insulating base portion body holding the conductor fixing portion and a flow path forming portion which is formed of the same material as the insulating base portion body and is exposed in the flow path to define the flow path together with the cooling device body.

## Description

### Technical Field

The present disclosure relates to a cooling device for an electrical conductor, a power conversion device, and a rotary electric machine.

Priority is claimed on Japanese Patent Application No. 2021-64570, filed April 6, 2021, the content of which is incorporated herein by reference.

### Background Art

Patent Document 1 describes a terminal block that electrically connects conductive members of a motor. The terminal block described in Patent Document 1 includes a heat sink that comes into contact with a refrigerant passing through a refrigerant flow path of a motor casing.

### Citation List

### Patent Document(s)

Patent Document 1: Japanese Patent No. 5672074

### Summary of Invention

### Technical Problem

The terminal block described in Patent Document 1 cools a metal terminal portion by transferring heat of the terminal portion to the heat sink via a molded resin portion which is an insulating material. However, since the structure of the terminal block becomes complicated and the heat transfer path from the terminal portion to the refrigerant flow path becomes long, there is a problem that it becomes difficult to further improve cooling performance.

The present disclosure has been made in view of the above-described circumstances and an object thereof is to provide a cooling device for an electrical conductor, a power conversion device, and a rotary electric machine capable of improving cooling performance by suppressing a complicated structure.

### Solution to Problem

In order to achieve the aforementioned objects, the following configuration is adopted.

According to a first aspect of the present disclosure, a cooling device for an electrical conductor includes: a cooling device body in which a flow path of refrigerant is formed, an opening portion communicating with the flow path being formed on an outer surface of the cooling device body; a conductor fixing portion which is allowed to be fixed an electrical conductor thereto; and an insulating base portion which is disposed between the conductor fixing portion and the cooling device body and is fixed to the cooling device body to block the opening portion, in which the cooling device body and the refrigerant are electrically insulated from the conductor fixing portion by the insulating base portion, and heat of the conductor fixing portion is allowed to be transferred to the cooling device body and the refrigerant through the insulating base portion, wherein the insulating base portion includes an insulating base portion body holding the conductor fixing portion and a flow path forming portion which is formed of the same material as the insulating base portion body and is exposed in the flow path to define the flow path together with the cooling device body.

According to a second aspect of the present disclosure, a power conversion device includes: the cooling device for the electrical conductor; an input conductor which is configured to serve as the electrical conductor; a power conversion unit that converts power input from the input conductor; and an output conductor which is formed to output power converted by the power conversion unit.

According to a third aspect of the present disclosure, a rotary electric machine includes: the cooling device for the electrical conductor; and an input conductor which is formed to serve as the electrical conductor, wherein the rotary electric machine generates a rotating magnetic field by power input from the input conductor to covert electrical energy into rotational energy.

### Advantageous Effects of Invention

According to a cooling device for an electrical conductor, a power conversion device, and a rotary electric machine, it is possible to improve cooling performance by suppressing a complicated structure.

### Brief Description of Drawings

FIG. 1 is a perspective view showing a schematic configuration of a power conversion device of a first embodiment of the present disclosure.
FIG. 2 is a perspective view of a cooling device for an electrical conductor of the first embodiment of the present disclosure.
FIG. 3 is an exploded perspective view of the cooling device for the electrical conductor of the first embodiment of the present disclosure.
FIG. 4 is a plan view of the cooling device of the first embodiment of the present disclosure.
FIG. 5 is a perspective view corresponding to FIG. 2 in a second embodiment of the present disclosure.
FIG. 6 is a perspective view when an insulating base portion of a first modified example of the first embodiment of the present disclosure is viewed from a flow path forming portion side.
FIG. 7 is a plan view of a cooling device for an electrical conductor of a second modified example of the first embodiment of the present disclosure.

### Description of Embodiments

### First Embodiment

Next, a cooling device for an electrical conductor and a power conversion device of a first embodiment of the present disclosure will be described with reference to the drawings.

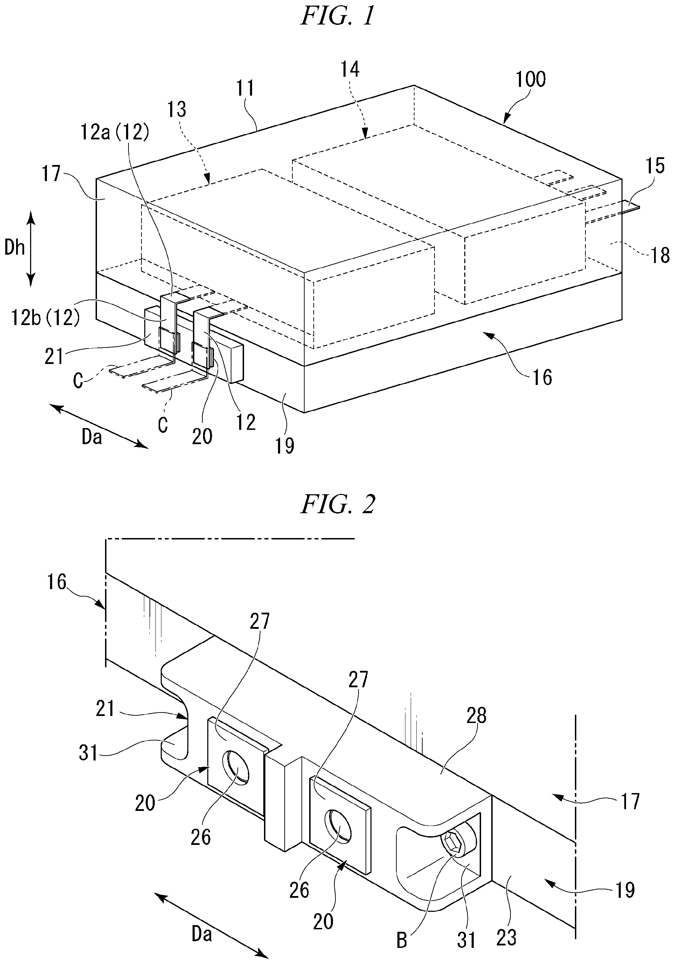

FIG. 1 is a perspective view showing a schematic configuration of the power conversion device of the first embodiment of the present disclosure. As shown in FIG. 1, a power conversion device 100 of this first embodiment includes a casing 11, an input conductor 12, a rectifying unit 13, a power conversion unit 14, an output conductor 15, and a cooling device 16. In this embodiment, the power conversion device 100 will be described using an inverter for controlling an electric motor (not shown) as an example.

The casing 11 forms the outer shell of the power conversion device 100. The casing 11 exemplified in this embodiment has a rectangular parallelepiped shape formed of synthetic resin or the like and an input conductor 12 and an output conductor 15 are drawn out from two side surfaces (hereinafter, referred to as an input side surface 17 and an output side surface 18) that are arranged back to back to each other.

The input conductor 12 is, for example, an electrical conductor which supplies DC power to the rectifying unit 13. The input conductor 12 of this embodiment is a bus bar formed of metal including copper or the like and includes a first input conductor portion 12a which extends in a direction intersecting the input side surface (outer surface) 17 of the casing 11 and a second input conductor portion 12b which extends along the input side surface 17 from the outer end portion of this first input conductor portion 12a. The first input conductor portion 12a penetrates the input side surface 17 of the casing 11. The second input conductor portion 12b of this embodiment extends from the first input conductor portion 12a to bend vertically toward the lower side of the paper surface of FIG. 1 (in other words, the side closer to the cooling device 16). The end portion of the input conductor 12 (in other words, the lower end portion of the second input conductor portion 12b) is fixed to a conductor fixing portion 20 of the cooling device 16 to be described later with a fixture (not shown) such as a bolt. In this embodiment, two input conductors 12, for example, an input conductor 12 connected to a P-type semiconductor region of the power conversion unit 14 and an input conductor 12 connected to an N-type semiconductor region thereof are provided.

The rectifying unit 13 rectifies the power input from the input conductor 12. The rectifying unit 13 of this embodiment includes a plurality of capacitors (not shown) that remove high frequency components and the like superimposed on the power input from the input conductor 12. The power having passed through the rectifying unit 13 is supplied to the power conversion unit 14. The rectifier 13 may be provided as necessary, and for example, the rectifier 13 may be omitted.

The power conversion unit 14 converts the power input from the input conductor 12. More specifically, the power conversion unit 14 includes switching elements such as MOSFETs and IGBTs and converts DC power input from the input conductor 12 via the rectifier 13 into AC power according to a control signal input from a control unit (not shown). In this embodiment, three power conversion units 14 are integrally formed to output three-phase alternating current. The input conductor 12 is branched and connected to these three power conversion units 14.

The output conductor 15 outputs power converted by the power conversion unit 14. More specifically, the output conductor 15 is a bus bar formed of metal containing copper or the like similarly to the input conductor 12 and penetrates, for example, the output side surface 18 of the casing 11 to extend linearly in a direction intersecting the output side surface 18. For example, a through hole (not shown) is formed at the end portion of the output conductor 15 in this embodiment and can be fixed to other electrical conductors (not shown) with a fixture such as bolt.

The cooling device 16 is configured to cool the electrical conductor. In this embodiment, the input conductor 12 is cooled as the electrical conductor. Furthermore, the cooling device 16 of this embodiment can simultaneously cool not only the input conductor 12 but also other components (for example, the power conversion unit 14) that generate heat in the power conversion device 100. For example, the outline of the cooling device 16 of this embodiment when viewed from above in FIG. 1 (in other words, in plan view) is formed to be the same as the outline of the casing 11 and the cooling device 16 is provided to be stacked below the casing 11 in FIG. 1. The cooling device 16 of this embodiment is integrally fixed to the casing 11.

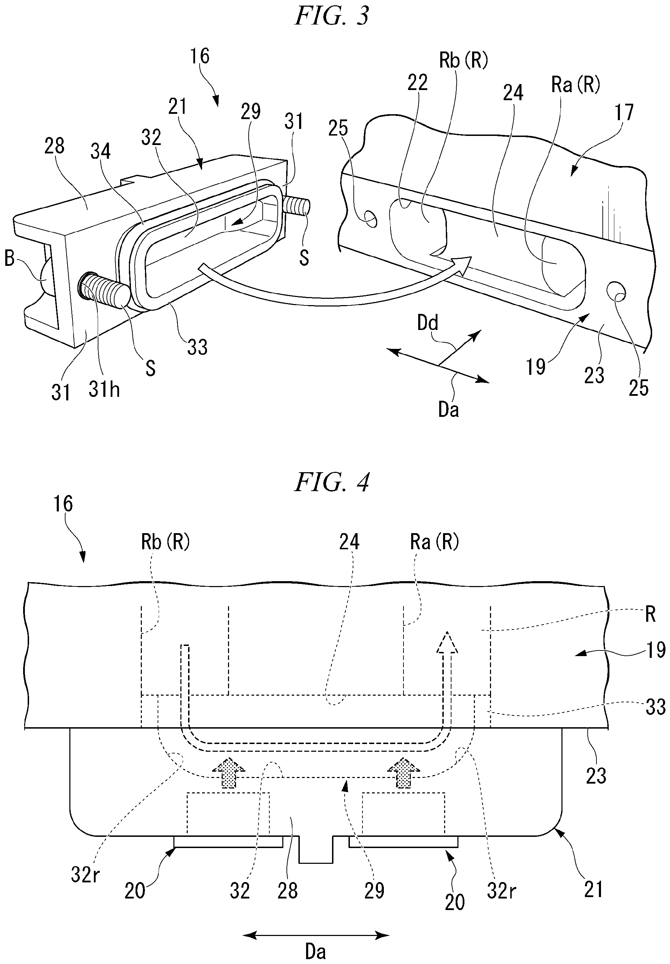

FIG. 2 is a perspective view of the cooling device for the electrical conductor of the first embodiment of the present disclosure. FIG. 3 is an exploded perspective view of the cooling device for the electrical conductor of the first embodiment of the present disclosure.

As shown in FIGS. 1 and 2, the cooling device 16 includes a cooling device body 19, a conductor fixing portion 20, and an insulating base portion 21.

The cooling device body 19 forms a flow path R (see FIG. 3) through which a refrigerant flows. A refrigerant is supplied from a refrigerant supply device (not shown) disposed outside to this cooling device body 19. The refrigerant supplied to the cooling device body 19 flows through the flow path of the cooling device body 19 and is discharged to the outside of the cooling device body 19 to be returned to, for example, the refrigerant supply device (not shown).

As shown in FIG. 3, the cooling device body 19 includes an opening portion 22 which communicates with the flow path R. The opening portion 22 of this embodiment is formed on an input side outer surface 23 of the cooling device body 19 facing the same direction as the input side surface 17 of the casing 11 in the outer surface of the cooling device body 19. Further, the opening portion 22 of this embodiment is an elongated hole in a direction (hereinafter, referred to as a longitudinal direction Da of the opening portion 22) perpendicular to a stacking direction Dh (see FIG. 1) in which the cooling device 16 and the casing 11 are stacked on the input side surface 17. A first flow path Ra and a second flow path Rb which extend in a direction (hereinafter, simply referred to as a depth direction Dd) perpendicular to the input side outer surface 23 on both sides of the opening portion 22 in the longitudinal direction Da respectively communicate with this opening portion 22. Further, a first folded flow path surface 24 is formed between the first flow path Ra and the second flow path Rb to be offset from the input side outer surface 23 in the depth direction Dd. Further, a screw hole 25 for attaching the insulating base portion 21 is formed on the input side outer surface 23 on both sides of the opening portion 22 in the longitudinal direction Da of the opening portion 22.

As shown in FIG. 2, the conductor fixing portion 20 is formed to be able to fix the input conductor 12 which is an electrical conductor. The conductor fixing portion 20 of this embodiment includes a fixing hole portion 26 which fixes a fixture (not shown) such as a bolt to be attachable and detachable and a fixing plate portion 27 which spreads in a direction perpendicular to a direction (in other words, the depth direction Dd) in which the fixing hole portion 26 extends from the opening peripheral edge of the fixing hole portion 26. The fixing hole portion 26 and the fixing plate portion 27 are integrally formed by metal such as copper or aluminum. The fixing plate portion 27 of this embodiment has a rectangular exposed plane when viewed from a direction in which the fixing hole portion 26 extends. Additionally, a structure for fixing the input conductor 12 to the conductor fixing portion 20 is not limited to bolt fastening. Further, if sufficient strength can be obtained when fixing the input conductor 12, the fixing plate portion 27 may be omitted.

Here, for example, an end portion of an external conductor C connected to a DC power supply or the like to overlap the end portion of the input conductor 12 is fixed to the conductor fixing portion 20 of this first embodiment by a fixture. That is, this conductor fixing portion 20 has a function as a relay terminal that relays the external conductor C and the input conductor 12. Then, the electrical resistance value of the contact portion between the end portion of the external conductor C fixed to the conductor fixing portion 20 and the end portion of the input conductor 12 increases due to the contact resistance. Therefore, voltage drop and temperature rise tend to occur in this contact portion when a current is applied.

As shown in FIGS. 2 and 3, the insulating base portion 21 is disposed to be disposed between the conductor fixing portion 20 and the cooling device body 19. The insulating base portion 21 is fixed to the cooling device body 19 to block the opening portion 22. This insulating base portion 21 electrically insulates the cooling device body 19 and the refrigerant flowing through the flow path R from the conductor fixing portion 20. Furthermore, the insulating base portion 21 is formed to be able to transfer the heat of the conductor fixing portion 20 to the cooling device body 19 and the refrigerant. As a material of forming the insulating base portion 21, for example, a material obtained by adding a filler capable of improving thermal conductivity to a synthetic resin having high electrical insulating performance can be used.

FIG. 4 is a plan view of the cooling device of the first embodiment of the present disclosure.

As shown in FIGS. 3 and 4, the insulating base portion 21 includes an insulating base portion body 28 and a flow path forming portion 29. The insulating base portion body 28 and the flow path forming portion 29 are formed of the same material. The insulating base portion body 28 holds the conductor fixing portion 20. The insulating base portion body 28 of this embodiment includes two insulating base fixing portions 31 fixed to the input side outer surface 23 of the cooling device body 19 on both sides in the longitudinal direction thereof. The insulating base fixing portion 31 of this embodiment includes a through hole 31h for inserting a male screw portion S of a fixture B such as a bolt.

The flow path forming portion 29 is exposed in the flow path R and defines the flow path R together with the cooling device body 19. In other words, the flow path forming portion 29 is disposed to face the opening portion 22 of the cooling device body 19 and blocks the opening portion 22. The flow path forming portion 29 of this embodiment includes a recessed portion 32, a projection portion 33, and a seal member 34. The recessed portion 32 is formed to be recessed in a direction approaching the conductor fixing portion 20 from the end surface on the side of the cooling device body 19 of the insulating base portion body 28. The recessed portion 32 of this embodiment has an elongated shape in the longitudinal direction Da and includes a curved surface 32r formed at both end portions of the longitudinal direction Da in FIG. 4 to be curved in a concave shape. The projection portion 33 is formed to protrude in the depth direction Dd along the peripheral edge of the opening portion 22 and to be allowed to fit with the inner peripheral surface of the opening portion 22. The projection portion 33 is formed in a tubular shape along the inner peripheral surface of the opening portion 22. The seal member 34 is provided between the projection portion 33 and the inner peripheral surface of the opening portion 22 and seals a gap between the flow path forming portion 29 and the insulating base portion 21. The seal member 34 of this embodiment is formed in a ring shape and is mounted on the outer peripheral surface of the projection portion 33. When the projection portion 33 is fitted into the opening portion 22, this seal member 34 is collapsed while being sandwiched between the outer peripheral surface of the projection portion 33 and the inner peripheral surface of the opening portion 22. Additionally, a ring-shaped groove for positioning the seal member 34 may be formed on the outer peripheral surface of the projection portion 33.

### (Operation and effect)

The cooling device 16 for the electrical conductor of the first embodiment includes the cooling device body 19 that forms the flow path R through which a refrigerant flows and has the opening portion 22 formed on the outer surface to communicate with the flow path, the conductor fixing portion 20 that is able to fix the input conductor 12 as an electrical conductor, and the insulating base portion 21 which is disposed between the conductor fixing portion 20 and the cooling device body 19, is fixed to the cooling device body 19 to block the opening portion 22, electrically insulates the cooling device body 19 and the refrigerant from the conductor fixing portion 20, and transfers the heat of the conductor fixing portion 20 to the cooling device body 19 and the refrigerant. Further, the insulating base portion 21 includes the insulating base portion body 28 which holds the conductor fixing portion 20 and the flow path forming portion 29 which is formed of the same material as the insulating base portion body 28 and is exposed in the flow path to define the flow path together with the cooling device body.

With such a configuration, even when a current flows to the input conductor 12 fixed to the conductor fixing portion 20 so that the temperature of the input conductor 12 rises, the heat of the input conductor 12 is transferred from the conductor fixing portion 20 to the insulating base portion 21 to exchange heat with the refrigerant flowing through the flow path via the flow path forming portion 29 formed of the same material as the insulating base portion body 28 of the insulating base portion 21. Thus, the heat transfer path of the insulating base portion 21 can be shortened. As a result, it is possible to improve cooling performance by suppressing a complicated structure of the cooling device 16 for the electrical conductor.

The flow path forming portion 29 of the cooling device 16 for the electrical conductor of the first embodiment further includes the recessed portion 32 which is recessed in a direction approaching the conductor fixing portion 20.

With such a configuration, it is possible to shorten the distance between the conductor fixing portion 20 and the refrigerant flowing through the flow path while ensuring the insulation distance between the input conductor 12 and the cooling device body 19. Thus, it is possible to efficiently cool the conductor fixing portion 20.

The flow path forming portion 29 of the cooling device 16 for the electrical conductor of the first embodiment further includes the projection portion 33 which is allowed to fit with the opening portion 22 while protruding along the inner peripheral surface of the opening portion 22. The flow path forming portion further includes the seal member 34 that is provided between the projection portion 33 and the opening portion 22 and seals a gap between the flow path forming portion 29 and the insulating base portion 21.

With such a configuration, the seal member 34 can be easily attached. Therefore, the burden on assembly workers can be reduced.
Further, the direction in which the seal member 34 is crushed between the opening portion 22 and the projection portion 33 can be different from the direction in which the seal member 34 is pressed by the refrigerant pressure. Thus, it is possible to suppress a decrease in sealing performance, for example, even when the refrigerant pressure is high and to more reliably seal a gap between the insulating base portion 21 and the cooling device body 19.

The power conversion device 100 of the first embodiment includes the cooling device 16 for the electrical conductor, the input conductor 12 which is an electrical conductor, the power conversion unit 14 which converts power input from the input conductor 12, and the output conductor 15 which outputs the power converted by the power conversion unit 14. Then, the cooling device 16 for the electrical conductor also serves as the cooling device 16 for a power converter.

With such a configuration, it is possible to cool the input conductor 12 which is an electrical conductor used in the power conversion device 100 without providing the cooling device 16 dedicated for cooling the electrical conductor. Thus, it is possible to efficiently cool the input conductor 12 while suppressing an increase in size of the power conversion device 100.

### Second Embodiment

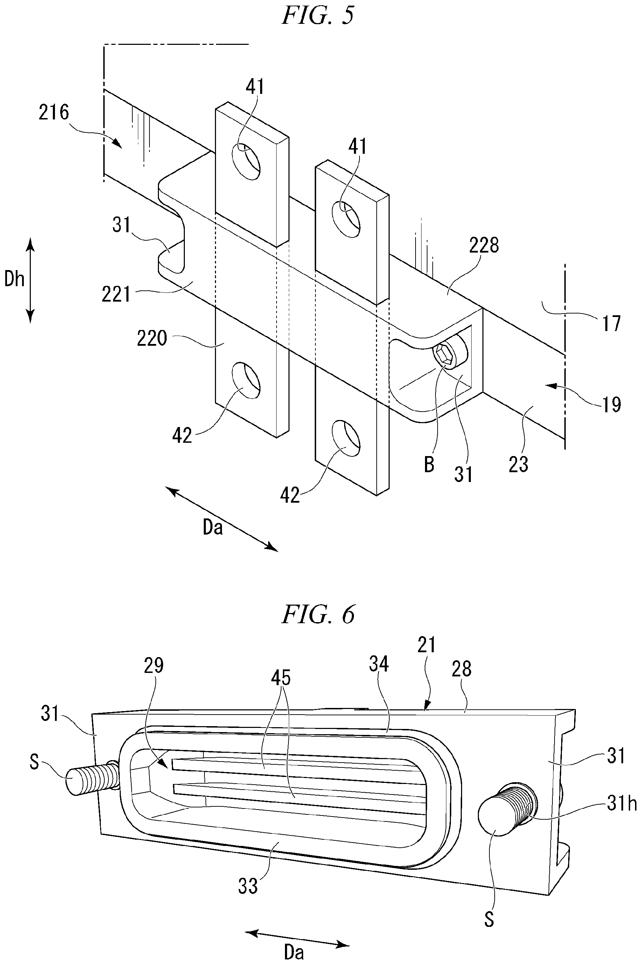

Next, a cooling device for an electrical conductor of a second embodiment of the present disclosure will be described with reference to the drawings. The cooling device for the electrical conductor of the second embodiment is different from that of the first embodiment only in the configuration of the conductor fixing portion. Therefore, the same parts as those of the first embodiment are denoted by the same reference numerals, and overlapping descriptions are omitted. FIG. 5 is a perspective view corresponding to FIG. 2 in the second embodiment of the present disclosure.

As shown in FIG. 5, a cooling device 216 of this second embodiment includes the cooling device body 19, a conductor fixing portion 220, and an insulating base portion 221 similarly to the cooling device 16 of the first embodiment. Additionally, the cooling device body 19 of this second embodiment has the same configuration as that of the first embodiment.

The conductor fixing portion 220 is formed to be able to fix the input conductor 12 of the power conversion device 100 which is an electrical conductor. The conductor fixing portion 220 of this second embodiment extends in the stacking direction Dh perpendicular to the longitudinal direction Da. The conductor fixing portion 220 of this second embodiment is formed of metal such as copper or aluminum. The conductor fixing portion 220 has a flat plate shape in which the length in the stacking direction Dh is greater than the length in the longitudinal direction Da and the length in the longitudinal direction Da is constant. In other words, the conductor fixing portion 220 is formed in a band shape with a constant width. Similarly to the first embodiment, two conductor fixing portions 220 are provided as the same number of the input conductors 12 and extend in parallel with a gap therebetween in the longitudinal direction Da of the opening portion 22. The upper portions of these conductor fixing portions 220 are provided with through holes 41 for fixing the input conductor 12 using a fixture (not shown) such as a bolt and a nut. On the other hand the lower portion of the conductor fixing portion 220 is provided with a through hole 42 for fixing the external conductor C extending from a DC power supply or the like using a fixture (not shown) such as a bolt and a nut.

The insulating base portion 221 is disposed to be disposed between the conductor fixing portion 20 and the cooling device body 19. The insulating base portion 221 is fixed to the cooling device body 19 to block the opening portion 22. This insulating base portion 221 electrically insulates the cooling device body 19 and the refrigerant from the conductor fixing portion 220. Furthermore, the insulating base portion 221 is formed to be able to transfer the heat of the conductor fixing portion 220 to the cooling device body 19 and the refrigerant. The insulating base portion 221 of this second embodiment is fixed to the conductor fixing portion 220 while vertically penetrating the conductor fixing portion 220. For example, the insulating base portion 221 and the conductor fixing portion 220 can be fixed with an adhesive or integrally molded by injection molding. As a material of forming the insulating base portion 221, for example, a material obtained by adding a filler to improve thermal conductivity to a synthetic resin having high electrical insulating performance can be used similarly to the first embodiment.

The insulating base portion 221 includes an insulating base portion body 228 and the flow path forming portion 29 (not shown in FIG. 5) similarly to the first embodiment. The insulating base portion body 228 and the flow path forming portion 29 are formed of the same material. The insulating base portion body 228 holds the conductor fixing portion 220. Further, the insulating base portion body 228 includes two insulating base fixing portions 31 which are fixed to the input side outer surface 23 of the cooling device body 19 on both outer sides of the longitudinal direction Da. These insulating base fixing portions 31 are fixed to the input side outer surface 23 of the cooling device body 19 by a fixture such as a bolt.

### (Operation and effect)

Thus, according to the cooling device 216 for the electrical conductor of the second embodiment, it is possible to increase the number of positions fixed by the fixture in the conductor fixing portion 220 compared to the first embodiment. Accordingly, even when it is not necessary to connect electrical conductors other than the input conductor 12 and the external conductor C to the conductor fixing portion 220 in a merged manner or in a branched manner, these can be easily connected. Therefore, versatility as a relay terminal can be improved.

### First Modified Example

FIG. 6 is a perspective view when the insulating base portion 21 of a first modified example of the first embodiment of the present disclosure is viewed from the side of the flow path forming portion 29.

For example, a cooling fin 45 formed of the same material as the insulating base portion body 28 may be provided inside the recessed portion 32 of the flow path forming portion 29 similarly to the first modified example shown in FIG. 6. The cooling fin 45 of this first modified example extends in the longitudinal direction Da of the recessed portion 32 which is an elongated hole. Further, a plurality of (for example, two) cooling fins 45 of this first modified example are provided at intervals in the up and down direction of the recessed portion 32 (in other words, the stacking direction Dh) perpendicular to the longitudinal direction Da inside the recessed portion 32.

According to such a configuration of this first modified example, since it is possible to increase the contact area between the refrigerant and the insulating base portion 21 by the cooling fin 45, it is possible to efficiently exchange heat between the refrigerant and the insulating base portion 21.

### Second Modified Example

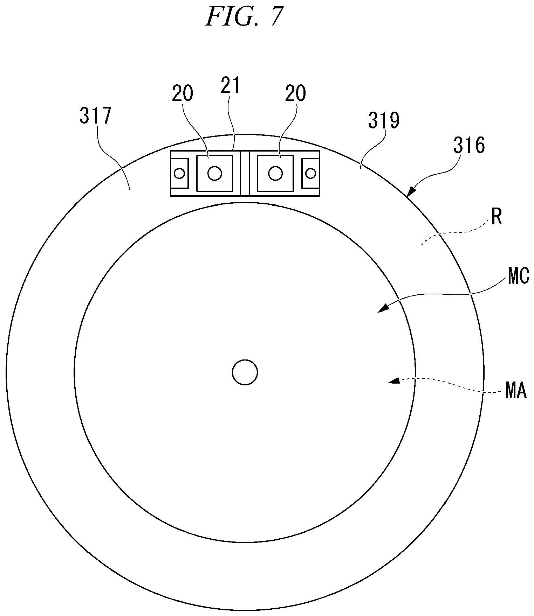

FIG. 7 is a plan view of a cooling device for an electrical conductor of a second modified example of the first embodiment of the present disclosure.

In the first embodiment, a case in which the cooling device 16 for the electrical conductor is provided integrally with the power conversion device 100 has been described. However, the cooling device 16 for the electrical conductor is not limited to being provided integrally with the power conversion device 100. For example, as shown in FIG. 7, the cooling device may be provided integrally with a rotary electric machine M such as a motor. The rotary electric machine M of this embodiment generates a rotating magnetic field using power input from the input conductor (not shown) of the rotary electric machine M to convert electrical energy into rotational energy. This rotary electric machine M includes a rotary electric machine body MA and a casing MC formed in a cylindrical shape storing the rotary electric machine body MA. A cooling device 316 cooling the rotary electric machine body MA is provided on the outer peripheral edge portion of the casing MC. This cooling device 316 is formed a ring shape to cover the outer surface of the rotary electric machine body MA over the entire circumstance.

A cooling device body 319 of this cooling device 316 includes a ring-shaped flow path R through which a refrigerant flows. Further, in this cooling device body 319, similarly to the cooling device body 19 of the first embodiment, the opening portion 22 (not shown) communicating with the flow path R is provided in an outer surface 317 and the insulating base portion 21 is fixed to the cooling device body 319 to block this opening portion 22 (not shown). Then, other electrical conductors (not shown) electrically connected to the output conductor 15 of the power conversion device 100 such as an inverter controlling the rotary electric machine body MA and the input conductor (not shown) of the rotary electric machine body MA are fixed to the conductor fixing portion 20 by a fixture such as a bolt. Additionally, since the configurations of the insulating base portion 21 and the conductor fixing portion 20 or the configurations of the opening portion 22 on the side of the cooling device body 319, the first flow path Ra, the second flow path Rb, and the first folded flow path surface 24 are the same as those of the first embodiment, detailed description will be omitted.

Thus, according to such a configuration of the second modified example, other electrical conductors (not shown) connected to the output conductor 15 of the power conversion device 100 such as an inverter controlling the rotary electric machine body MA and the input conductor 12 of the rotary electric machine body MA can be cooled as the electrical conductors. Further, it is possible to cool at least the input conductor used in the rotary electric machine body MA as the electrical conductor without providing the cooling device dedicated for cooling the electrical conductor. Thus, it is possible to efficiently cool at least the input conductor of the rotary electric machine M while suppressing an increase in size of the rotary electric machine M.

### Other Embodiments

The present disclosure is not limited to the configurations of the embodiments and modified examples described above, and design changes can be made without departing from the gist thereof.

For example, in the first and second embodiments, an inverter has been described as an example of the power conversion device 100, but the power conversion device 100 is not limited to the inverter. For example, a device such as a converter or a combination of an inverter and a converter may be used to convert power using a power semiconductor element that is a heat generating component. Further, the power device may include a heat generating component separated from the power semiconductor element.

Further, in the embodiments and modified examples, a bus bar is illustrated as the electrical conductor, but the electrical conductor is not limited to the bus bar. The electrical conductor may be, for example, a covered wire or the like. Further, although a case has been described in which two conductor fixing portions 20 and 220 are provided in the cooling devices 16, 216, and 316 of the embodiments and modified examples, only one or three or more conductor fixing portions 20 and 220 may be provided.

Further, in the embodiments and modified examples, although a case has been described in which the cooling devices 16, 216, and 316 for the electrical conductors are provided integrally with the power conversion device 100 or the rotary electric machine M, the present disclosure is not limited these configurations. For example, the cooling devices 16, 216, and 316 for the electrical conductors may be provided separately from the power conversion device 100 or the rotary electric machine M. Further, although a case has been described in which the electrical conductor used in the power conversion device 100 or the rotary electric machine M is cooled, the electrical conductor as a cooling target is not limited to the electrical conductor used in the power conversion device 100 or the rotary electric machine M. Any electrical conductor whose temperature may rise may be cooled by the cooling devices 16, 216, and 316 for the electrical conductors of the present disclosure.

### Appendix

The casing and the power conversion device described in the embodiments are understood, for example, as below.
(1) According to a first aspect, the cooling devices 16, 216, and 316 for the electrical conductors include: the cooling device bodies 19 and 319 in which the flow path R of refrigerant is formed, the opening portion 22 communicating with the flow path R being formed on the input side surface (outer surface) 17 of the cooling device bodies; the conductor fixing portions 20 and 220 which are allowed to be fixed the input conductor (electrical conductor) 12; and the insulating base portions 21 and 221 which are disposed between the conductor fixing portions 20 and 220 and the cooling device bodies 19 and 319 and are fixed to the cooling device bodies 19 and 319 to block the opening portion 22, in which the cooling device bodies 19 and 319 and the refrigerant are electrically insulated from the conductor fixing portions 20 and 220 by the insulating base portions 21 and 221, and heat of the conductor fixing portions 20 and 220 are allowed to be transferred to the cooling device bodies 19 and 319 and the refrigerant through the insulating base portions 21 and 221, wherein the insulating base portions 21 and 221 include the insulating base portion main bodies 28 and 228 holding the conductor fixing portions 20 and 220 and the flow path forming portion 29 which is formed of the same material as the insulating base portion main bodies 28 and 228 and is exposed in the flow path R to define the flow path R together with the cooling device bodies 19 and 319.

With such a configuration, even when a current flows to the electrical conductor 12 fixed to the conductor fixing portions 20 and 220 so that the temperature of the electrical conductor 12 rises, the heat of the electrical conductor 12 is transferred from the conductor fixing portions 20 and 220 to the insulating base portions 21 and 221 to exchange heat with the refrigerant flowing through the flow path R via the flow path forming portion 29 formed of the same material as the insulating base portion main bodies 28 and 228 of the insulating base portions 21 and 221. Thus, the heat transfer path of the insulating base portions 21 and 221 can be shortened. As a result, it is possible to improve cooling performance by suppressing a complicated structure of the cooling devices 16, 216, and 316 for the electrical conductors.

Examples of the electrical conductor 12 include the input conductor.

(2) According to a second aspect, the flow path forming portion 29 of (1) may include the recessed portion 32 which is recessed in a direction approaching the conductor fixing portions 20 and 220.

With such a configuration, it is possible to shorten the distance between the conductor fixing portion 20 and the refrigerant flowing through the flow path R while ensuring the insulation distance between the input conductor 12 and the cooling device body 19. Thus, it is possible to efficiently cool the conductor fixing portion 20.

(3) According to a third aspect, the flow path forming portion 29 of (2) may include the cooling fin 45 which is disposed inside the recessed portion 32 and is formed of the same material as the insulating base portion main bodies 28 and 228.

With such a configuration, since it is possible to increase the contact area between the refrigerant and the insulating base portion 21 by the cooling fin 45, it is possible to efficiently exchange heat between the refrigerant and the insulating base portion 21.

(4) According to a fourth aspect, in the cooling devices 16, 216, and 316 for the electrical conductors of any one of (1) to (3), the flow path forming portion further includes the projection portion 33 which is protruded outward from the inner peripheral surface of the opening portion 22 and which is allowed to fit with the opening portion 22, and the cooling devices may include the seal member 34 which is installed between the projection portion 33 and the opening portion 22 to seal a gap between the flow path forming portion 29 and the insulating base portions 21 and 221.

With such a configuration, the seal member 34 can be easily attached. Therefore, the burden on assembly workers can be reduced.
Further, the direction in which the seal member 34 is crushed between the opening portion 22 and the projection portion 33 can be different from the direction in which the seal member 34 is pressed by the refrigerant pressure. Thus, it is possible to suppress a decrease in sealing performance, for example, even when the refrigerant pressure is high and to more reliably seal a gap between the insulating base portion 21 and the cooling device body 19.

(5) According to a fifth aspect, the power conversion device 100 includes: the cooling devices 16 and 216 for the electrical conductors of any one of (1) to (4); the input conductor 12 which is formed to serve as the electrical conductor; the power conversion unit 14 which is configured to convert power input from the input conductor 12; and the output conductor 15 which is formed to output power converted by the power conversion unit 14.

With such a configuration, it is possible to cool the input conductor 12 which is an electrical conductor used in the power conversion device 100 without providing the cooling device 16 dedicated for cooling the electrical conductor. Thus, it is possible to efficiently cool the input conductor 12 while suppressing an increase in size of the power conversion device 100.

(6) According to a sixth aspect, the rotary electric machine M includes: the cooling device 316 for the electrical conductor of any one of (1) to (4); and the input conductor which is formed to serve as the electrical conductor, wherein the rotary electric machine generates a rotating magnetic field by power input from the input conductor to convert electrical energy into rotational energy. Examples of the rotary electric machine M include an electric motor or a generator.

With such a configuration, other electrical conductors (not shown) connected to the output conductor 15 of the power conversion device 100 such as an inverter controlling the rotary electric machine M and the input conductor of the rotary electric machine M can be cooled as the electrical conductors. Further, it is possible to cool at least the input conductor used in the rotary electric machine M as the electrical conductor without providing the cooling device dedicated for cooling the electrical conductor. Thus, it is possible to efficiently cool at least the input conductor of the rotary electric machine M while suppressing an increase in size of the rotary electric machine M.

### Industrial Applicability

The present disclosure relates to a cooling device for an electrical conductor, a power conversion device, and a rotary electric machine. According to the cooling device of the present disclosure, it is possible to improve cooling performance by suppressing a complicated structure.

### Reference Signs List

11 Casing
12 Input conductor (electrical conductor)
12a First input conductor portion
12b Second input conductor portion
13 Rectifying unit
14 Power conversion unit
15 Output conductor
16, 216, 316 Cooling device
17 Input side surface (outer surface)
18 Output side surface
19, 319 Cooling device body
20, 220 Conductor fixing portion
21, 221 Insulating base portion
22 Opening portion
23 Input side outer surface
24 First folded flow path surface
25 Screw hole
26 Fixing hole portion
27 Fixing plate portion
28, 228 Insulating base portion body
29 Flow path forming portion
31 Insulating base fixing portion
31h Through hole
32 Recessed portion
32r Curved surface
33 Projection portion
34 Seal member
41, 42 Through hole
45 Cooling fin
100 Power conversion device
B Fixture
C External conductor
R Flow path
Ra First flow path
Rb Second flow path
M Rotary electric machine
MA Rotary electric machine body
MC Casing

## Claims

1. A cooling device for an electrical conductor comprising:
a cooling device body in which a flow path of refrigerant is formed and on an outer surface of which an opening portion communicating with the flow path is formed;
a conductor fixing portion which is allowed to be fixed an electrical conductor thereto; and
an insulating base portion which is disposed between the conductor fixing portion and the cooling device body and is fixed to the cooling device body to block the opening portion, in which the cooling device body and the refrigerant are electrically insulated from the conductor fixing portion by the insulating base portion and heat of the conductor fixing portion is allowed to be transferred to the cooling device body and the refrigerant through the insulating base portion,
wherein the insulating base portion includes:
an insulating base portion body holding the conductor fixing portion; and
a flow path forming portion which is formed of the same material as the insulating base portion body and is exposed in the flow path to define the flow path together with the cooling device body.

2. The cooling device for the electrical conductor according to claim 1,
wherein the flow path forming portion includes a recessed portion which is recessed in a direction approaching the conductor fixing portion.

3. The cooling device for the electrical conductor according to claim 2,
wherein the flow path forming portion includes a cooling fin which is disposed inside the recessed portion and which is formed of the same material as the insulating base portion body.

4. The cooling device for the electrical conductor according to any one of claims 1 to 3,
wherein the flow path forming portion further includes a projection portion which is protruded outward from an inner peripheral surface of the opening portion and which is allowed to fit with the opening portion, and
wherein the cooling device further includes a seal member which is installed between the projection portion and the opening portion to seal a gap between the flow path forming portion and the insulating base portion.

5. A power conversion device comprising:
the cooling device for the electrical conductor according to any one of claims 1 to 4;
an input conductor which is formed to serve as the electrical conductor;
a power conversion unit which is configured to convert power input from the input conductor; and
an output conductor which is formed to output power converted by the power conversion unit.

6. A rotary electric machine comprising:
the cooling device for the electrical conductor according to any one of claims 1 to 4; and
an input conductor which is formed to serve as the electrical conductor,
wherein the rotary electric machine generates a rotating magnetic field by power input from the input conductor to convert electrical energy into rotational energy.
